# EUROPÄISCHE PATENTSCHRIFT

(11) **EP 2 258 000 B1**
(45) Veröffentlichungstag und Bekanntmachung des Hinweises auf die Patenterteilung: **23.03.2016**
(21) Anmeldenummer: 09728784.1
(22) Anmeldetag: 26.03.2009
(51) Int. Cl.: H01L 33/44, H01L 33/56, H01L 33/62

(54) **OPTOELEKTRONISCHES HALBLEITERBAUTEIL UND VERFAHREN ZUR HERSTELLUNG EINES OPTOELEKTRONISCHEN HALBLEITERBAUTEILS**
OPTOELECTRONIC SEMICONDUCTOR COMPONENT AND METHOD FOR PRODUCING SAID COMPONENT
COMPOSANT SEMICONDUCTEUR OPTOÉLECTRONIQUE ET PROCÉDÉ DE FABRICATION D'UN COMPOSANT SEMICONDUCTEUR OPTOÉLECTRONIQUE

(30) Priorität: 31.03.2008 DE 102008016487
(43) Veröffentlichungstag der Anmeldung: 08.12.2010
(73) Patentinhaber: OSRAM Opto Semiconductors GmbH, 93055 Regensburg (DE)
(72) Erfinder: WEGLEITER, Walter, 93152 Nittendorf (DE); WIRTH,Ralph, 93098 Mintraching - Auhof (DE); BARCHMANN, Bernd, 93059 Regensburg (DE)
(74) Vertreter: Epping - Hermann - Fischer
(86) Internationale Anmeldenummer: PCT/DE2009/000417
(87) Internationale Veröffentlichungsnummer: WO 2009/121339

(56) Entgegenhaltungen:
- EP-A- 1 684 363
- WO-A-2006/034671
- WO-A-2008/018336
- DE-A1- 10 339 985
- US-A1- 2004 158 977
- US-A1- 2006 186 428
- US-A1- 2007 215 998

## Beschreibung

Es wird ein optoelektronisches Halbleiterbauteil angegeben. Darüber hinaus wird ein Verfahren zur Herstellung eines solchen optoelektronischen Halbleiterbauteils angegeben.

Optoelektronische Bauteile wie etwa Leucht- oder Photodioden haben eine breite technische Anwendung gefunden. Einige Gesichtspunkte, die der Verbreitung solchen Bauteile Vorschub leisteten, sind etwa deren hohe Effizienz und Widerstandsfähigkeit gegen äußere Belastungen sowie Umwelteinflüsse. Beispielsweise können optoelektronische Bauteile etwa Feuchtigkeit oder Wärme gut widerstehen und sind auch bei geeigneter Bauart widerstandsfähig gegen mechanische Beanspruchungen. Neben hoher Effizienz weisen optoelektronische Bauteile auch eine hohe Lebensdauer, eine kompakte Bauweise und vielfältige Ausgestaltungsmöglichkeiten auf und sind außerdem zu vergleichsweise geringen Fertigungskosten herstellbar. Entscheidend für eine Vielzahl eben genannten Eigenschaften ist oft die Hausung des optoelektronischen Bauteils, auf die daher im Regelfall besonderer Wert zu legen ist.

In der Druckschrift DE 103 39 985 A1 ist ein optoelektronisches Bauelement und ein Herstellungsverfahren hierfür angegeben.

Die Druckschrift EP 1 684 363 A2 betrifft eine Silikonverkapselte Leuchtdiode.

Ein optoelektronisches Bauteil ist in der Druckschrift US 2004/0158977 A1 beschrieben.

Ein Leuchtdioden-Package ist in der Druckschrift US 2007/0215998 A1 offenbart.

In der Druckschrift US 2006/0186428 A1 ist eine Leuchtdiode mit einer Einkapselung wiedergegeben.

Eine zu lösende Aufgabe besteht darin, ein alterungsbeständiges optoelektronisches Bauteil anzugeben. Eine weitere zu lösende Aufgabe besteht darin, ein Verfahren zur Herstellung eines solchen optoelektronischen Bauteils anzugeben.

Das optoelektronische Halbleiterbauteil umfasst einen Anschlussträger mit einer Anschlussseite. Der Anschlussträger kann etwa in Form einer Leiterplatte gestaltet sein, die geätzte, aufgedruckte, oder aufgedampfte Leiterbahnen umfasst. Der Anschlussträger kann mechanisch flexibel ausgestaltet sein, beispielsweise als flexible Leiterplatte insbesondere auf Polyimid-Basis, oder auch aus mechanisch starren Materialien wie etwa Keramiken oder Gläsern bestehen. Vorzugsweise weist der Anschlussträger eine hohe thermische Leitfähigkeit auf, so dass er dazu geeignet ist, die im Betrieb des optoelektronischen Halbleiterbauteils entstehende elektrische Verlustleistung, die hauptsächlich in einer Wärmeentwicklung resultiert, gut nach außen abzuleiten.

Je nach Erfordernissen kann es von Vorteil sein, dass der Anschlussträger in einem bestimmten Spektralbereich des elektromagnetischen Spektrums durchlässig ist. Auch die geometrischen Abmessungen des Anschlussträgers können an die jeweiligen Erfordernisse einer konkreten Anwendung angepasst werden. Die Anschlussseite des Anschlussträgers kann etwa flach beziehungsweise eben ausgestaltet und dazu geeignet sein, mindestens einen optoelektronischen Halbleiterchip aufzunehmen. Im Regelfall weist der Anschlussträger eine Anschlussseite auf, es ist jedoch nicht ausgeschlossen, dass etwa beide Seiten eines zum Beispiel flächig ausgestalteten Anschlussträgers als Anschlussseiten Verwendung finden können.

Das optoelektronische Halbleiterbauteil umfasst mindestens einen optoelektronischen Halbleiterchip. Der Halbleiterchip ist dazu ausgestaltet, im Betrieb elektromagnetische Strahlung entweder zu empfangen oder zu emittieren. Der Halbleiterchip kann als Fotodiode und somit als Sensor ausgestaltet sein, oder als lichtemittierendes Element, etwa in Form einer Leuchtdiode oder Laserdiode. Der Halbleiterchip kann flächig ausgestaltet sein und beispielsweise eine quadratische oder rechteckige Grundfläche aufweisen. Ebenso möglich ist es, dass der Halbleiterchip etwa hexagonale oder runde Grundflächen aufweist, die zum Beispiel eine hochdichte Anordnung der Halbleiterchips auf einem Anschlussträger erlauben. Der Dicke des Halbleiterchips sind keine strikten Grenzen gesetzt, bevorzugt beträgt die Dicke jedoch weniger als 200 µm, insbesondere weniger als 50 µm. Der Halbleiterchip kann zum Beispiel als Dünnfilmchip ausgeformt sein, wie in der Druckschrift WO 2005/081319 A1 beschrieben.

Die elektrischen Kontaktierungen des Halbleiterchips können sich sämtlich an der Ober- oder an der Unterseite des Chips befinden, jeweils an den Flanken des Halbleiterchips oder aber auch je an Ober- und Unterseite des Chips angebracht sein. Zudem weist der Halbleiterchip eine Strahlungsdurchtrittsfläche auf, durch die das vom Halbleiterchip zu emittierende oder zu empfangende Licht den Halbleiterchip verlässt beziehungsweise durch diese Fläche in diesen eintritt. Die Strahlungsdurchtrittsfläche kann eben ausgestaltet sein oder Strukturierungen aufweisen, die es dem ein- beziehungsweise ausfallenden Licht erleichtern, durch die Strahlungsdurchtrittsfläche hindurch zu treten.

Das optoelektronische Halbleiterbauteil umfasst eine haftvermittelnde Zwischenfolie. Diese Zwischenfolie ist auf der Anschlussseite des Anschlussträgers aufgebracht und bedeckt diese mindestens stellenweise. Die Zwischenfolie kann homogen aus einem einzigen Material gebildet sein oder auch eine mehrlagige Struktur aufweisen. Insbesondere ist es möglich, dass die haftvermittelnde Zwischenfolie Strukturierungen zum Beispiel in Form von Ausnehmungen aufweist, oder dass auf dieser Zwischenfolie etwa elektrisch leitfähige Strukturen angebracht sind. Bevorzugt liegt die Dicke der Zwischenfolie im Bereich von 20 µm bis 200 µm, insbesondere zwischen 35 µm und 60 µm.

Das optoelektronische Halbleiterbauteil umfasst mindestens einen strahlungsdurchlässigen Vergusskörper. Strahlungsdurchlässig bedeutet hierbei, dass der Vergusskörper im für den Betrieb des Halbleiterchips relevanten elektromagnetischen Spektralbereich im Wesentlichen als transparent oder transluzent anzusehen ist. Das heißt, der Vergusskörper absorbiert im relevanten Spektralbereich weniger als 20%, bevorzugt weniger als 10%, besonders bevorzugt weniger als 5% der Strahlung.

Es erstreckt sich der Vergusskörper nur über oder an einer einzigen Hauptseite des Anschlussträgers. Ebenso bevorzugt sind Stirnseiten des Anschlussträgers frei von dem Vergusskörper und/oder der Zwischenfolie. Mit anderen Worten umgibt der Vergusskörper den Anschlussträger nicht an mehreren Seiten.

Das optoelektronische Halbleiterbauteil umfasst einen Anschlussträger mit einer Anschlussseite und mindestens einen optoelektronischen Halbleiterchip, der auf der Anschlussseite angebracht und mit dem Anschlussträger elektrisch verbunden ist. Die Anschlussseite kann mindestens eine Anschlussfläche aufweisen, die dazu ausgestaltet ist, mit den elektrischen Kontaktierungen des Hableiterchips verbunden zu werden. Die Anschlussfläche kann beispielsweise als Löt- oder Klebeflächen gestaltet sein. Weiterhin umfasst das Halbleiterbauteil eine haftvermittelnde Zwischenfolie, die auf der Anschlussseite angebracht ist und diese mindestens teilweise bedeckt. Zudem weist das Halbleiterbauteil mindestens einen strahlungsdurchlässigen Vergusskörper auf, der den Halbeiterchip zumindest teilweise umgibt, wobei der Vergusskörper mittels der Zwischenfolie mit dem Anschlussträger mechanisch verbunden ist.

Die haftvermittelnde Zwischenfolie ist dementsprechend derart ausgestaltet, dass sie auf dem Anschlussträger beziehungsweise auf dessen Anschlussseite eine Haftung aufweist. Außerdem soll die Zwischenfolie eine haftende Verbindung mit dem Vergusskörper aufweisen. Beispielsweise ist es möglich, dass die Haftung zwischen Zwischenfolie und Anschlussträger besser ist, als die Haftung zwischen Vergusskörper und Anschlussträger. Ferner ist es dann möglich, dass die Haftung zwischen Vergusskörper und Zwischenfolie gegenüber der Haftung zwischen Vergusskörper und Anschlussträger verbessert ist. Bevorzugt ist die Haftung zwischen Vergusskörper und Anschlussträger aufgrund der Verwendung der Zwischenfolie um mindestens einen Faktor 1,5 verbessert, besonders bevorzugt um mindestens einen Faktor 2.

Durch eine solche Zwischenfolie wird eine dauerhafte, mechanisch stabile Verbindung zwischen Anschlussträger und Vergusskörper gewährleistet. Es ist nicht notwendig, dass die gesamte dem Anschlussträger zugewandte Seite des Vergusskörpers in direktem Kontakt zur Zwischenfolie steht. Insbesondere können etwa elektrische Verbindungen zwischen Vergusskörper und Zwischenfolie liegen.

Auch kann, mindestens stellenweise, die mechanische Verbindung zwischen Vergusskörper und Anschlussträger indirekt erfolgen, so dass beispielsweise der Vergusskörper auf der Zwischenfolie haftet, diese wiederum auf einem Halbleiterchip und der Halbleiterchip mit dem Anschlussträger direkt verbunden ist. Ebenso möglich ist es, dass der Halbleiterchip, über den die Verbindung zwischen Zwischenfolie und Anschlussträger vermittelt wird, indirekt mit dem Anschlussträger verbunden ist, zum Beispiel über eine Umverdrahtungsebene, einen Kühlkörper oder einen zum Beispiel keramischen Zwischenträger. Der Vergusskörper umgibt den Halbleiterchip etwa an dessen Strahlungsdurchtrittsfläche und an den Chipflanken. Unter Chipflanken sind hierbei diejenigen Seitenflächen des Halbleiterchips zu verstehen, die beispielsweise quer zur Anschlussseite oder zu einer Anschlussfläche ausgerichtet sind und die Strahlungsdurchtrittsfläche mit der der Anschlussseite zugewandten Fläche des Halbleiterchips verbinden.

Ein derart gestaltetes optoelektronisches Halbleiterbauteil ist alterungsbeständig und weist gute optische Eigenschaften auf.

Gemäß zumindest einer Ausführungsform des optoelektronischen Halbleiterbauteils ist die Strahlungsdurchtrittsfläche des Halbleiterchips zumindest stellenweise von der Zwischenfolie bedeckt. Insbesondere kann die gesamte Strahlungsdurchtrittsfläche von der Zwischenfolie bedeckt sein. Die Zwischenfolie ist hierbei bevorzugt durchlässig für die vom Halbleiterchip zu empfangende oder zu emittierende elektromagnetische Strahlung, mindestens in einem Teilbereich des relevanten Spektralbereichs. Speziell kann die Zwischenfolie transparent im relevanten Spektralbereich sein. Durch eine solche Anordnung beziehungsweise Ausgestaltung der Zwischenfolie kann das optoelektronische Halbleiterbauteil auf einfache Art und Weise hergestellt werden.

Es ist die Zwischenfolie mit einer Silikonfolie gestaltet. Das heißt, die Zwischenfolie umfasst eine Silikonfolie oder besteht gänzlich aus einer Silikonfolie. Bevorzugt bestehen Zwischenfolie und Vergusskörper aus demselben Material oder aus Materialien, die eine gute Haftung aneinander ermöglichen. Da Silikon elektromagnetischer Strahlung, besonders im blauen und nahen ultravioletten Spektralbereich, gut widersteht, kann durch eine solche Zwischenfolie ein alterungsbeständiges optoelektronisches Bauteil realisiert werden.

Gemäß zumindest einer Ausführungsform des optoelektronischen Halbleiterbauteils ist die Zwischenfolie mit einem Material gestaltet oder besteht aus einem solchen Material, das für die Strahlung undurchlässig ist. Mit anderen Worten ist die Zwischenfolie weder transparent noch transluzent. Bevorzugt weist die Zwischenfolie dann an der Strahlungsdurchtrittsfläche mindestens eine Ausnehmung oder mindestens eine Öffnung auf, so dass die Strahlungsdurchtrittsfläche mindestens stellenweise frei von der Zwischenfolie ist.

Es ist zwischen der Zwischenfolie, der Anschlussseite und Chipflanken ein Hohlraum gebildet. Mit anderen Worten, die Zwischenfolie überspannt den Halbleiterchip dann zeltartig. Die Chipflanken können hierbei gänzlich unbedeckt von der Zwischenfolie bleiben oder auch zu einem Großteil von dieser bedeckt sein. Sind in einem nachfolgenden, zum Beispiel Lithographie- oder Bedampfungsschritt etwa elektrische Leiterbahnen auf der Zwischenfolie anzubringen, so ist es von Vorteil, wenn der gebildete Hohlraum ein relativ großes Volumen aufweist, so dass die Steigung der Zwischenfolie parallel zur Ausrichtung der Anschlussseite nicht zu groß wird. Dadurch wird verhindert, dass in zu steil ausgerichteten Teilen der Zwischenfolie bei einem Bedampfungsprozess etwa zu wenig Material in diesen zu steilen Bereichen abgeschieden wird. Auch eine photolithografische Strukturierung ist nur in Bereichen möglich, in denen die Zwischenfolie nicht zu steil zur Anschlussseite ausgerichtet ist. Nicht zu steil bedeutet hierbei, dass der Winkel zwischen der durch die Strahlungsdurchtrittsfläche des Halbleiterchips definierten Ebene und der der Anschlussseite abgewandten Fläche der Zwischenfolie kleiner ist als 45°, bevorzugt kleiner als 30°.

Weist die Strahlungsdurchtrittsfläche Strukturierungen auf, so wird die Ebene dadurch definiert, dass über die Strukturierung der Strahlungsdurchtrittsfläche räumlich gemittelt wird, und zwar in Richtung senkrecht zur Hauptausbreitungsebene der Zwischenfolie.

Es ist der Vergusskörper mit einem Silikon gestaltet. Silikon ist besonders alterungsbeständig gegenüber elektromagnetischer Strahlung in blauen beziehungsweise UV-Spektralbereich. Bevorzugt ist der Vergusskörper einstückig ausgeführt. Ebenso möglich ist es, dass der Vergusskörper etwa mehrere Schichten beziehungsweise schalenartige Strukturen aufweist, die auch aus unterschiedlichen Materialien geformt sein können. Alternativ kann der Vergusskörper auch aus einem Epoxydharz-Silikon-Hybridmaterial ausgestaltet sein.

Gemäß zumindest einer Ausführungsform des optoelektronischen Halbleiterbauteils enthalten der Vergusskörper und/oder die Zwischenfolie zumindest eine Beimengung in Form eines Diffusor-, Konversions- oder Filtermittels. Vergusskörper und/oder Zwischenfolie können insbesondere je mehrere Beimengungen beinhalten, wobei Vergusskörper und Zwischenfolie auch unterschiedlich ausgeprägte Beimengungen enthalten können. Ist der Halbleiterchip etwa als Photodiode ausgestaltet, so kann beispielsweise der Vergusskörper auch mehrere Filtermittel enthalten, die nur Licht in einem gewissen Spektralbereich zum Halbleiterchip hin durchlassen. Über ein geeignetes Konversionsmittel als Beimengung kann beispielsweise eine blau emittierende Leuchtdiode dazu verwendet werden, um ein Halbleiterbauelement als Weißlichtquelle zu verwenden. Über Diffusormittel wie etwa TiO₂-Partikel, beispielsweise in der Zwischenfolie, ist es möglich, eine über deren gesamte strahlende Fläche homogen abstrahlende Beleuchtungseinrichtung zu realisieren.

Gemäß zumindest einer Ausführungsform des optoelektronischen Halbleiterbauteils ist der Anschlussträger mit einem Metall oder einer Metalllegierung, einem Kunststoff oder einer Keramik gestaltet. Der Anschlussträger kann aus einem einzigen Material, beispielsweise aus Kupfer, bestehen, oder auch ein Mehrschichtsystem sein, das beispielsweise eine besonders gute thermische Leitfähigkeit aufweist. Über die Wahl geeigneter Keramiken kann der Anschlussträger im relevanten Spektralbereich etwa transparent oder reflektierend sein.

Gemäß zumindest einer Ausführungsform des optoelektronischen Halbleiterbauteils ist dieses bis auf Anschlussträger, Zwischenfolie und Vergusskörper gehäusefrei. Zwischenfolie und/oder Vergusskörper können Beimengungen aufweisen. Ein derartiges Halbleiterbauteil kann besonders kompakt hergestellt werden, umfasst wenige Komponenten und ist daher auch kostengünstig.

Gemäß zumindest einer Ausführungsform des optoelektronischen Halbleiterbauteils ist die Strahlungsdurchtrittsfläche des Halbleiterchips dem Anschlussträger abgewandt. Ferner überdeckt der Vergusskörper, in einer Richtung senkrecht zur Strahlungsdurchtrittsfläche, den gesamten Halbleiterchip.

Gemäß zumindest einer Ausführungsform des optoelektronischen Halbleiterbauteils ist der Vergusskörper als optisches Element gestaltet. Zum Beispiel bildet der Vergusskörper eine Linse aus.

Gemäß zumindest einer Ausführungsform des optoelektronischen Halbleiterbauteils wird von der Zwischenfolie, dem Anschlussträger und den elektrischen Leitungen ein weiterer Hohlraum eingeschlossen. Alternativ ist der weitere Hohlraum vom Halbleiterchip, dem Anschlussträger und den elektrischen Leitungen eingeschlossen, der weitere Hohlraum weist dann also bevorzugt keinen Kontakt zur Zwischenfolie auf. Auch ein Isolator, der sich zum Beispiel zwischen dem Anschlussträger und den elektrischen Leitungen befindet, kann an den weiteren Hohlraum grenzen. Der weitere Hohlraum ist zum Beispiel mit einem Gas gefüllt oder evakuiert. Jedoch ist der weitere Hohlraum frei von einer Flüssigkeit oder einem Festkörper.

Es wird darüber hinaus ein Verfahren zur Herstellung eines optoelektronischen Halbleiterbauteils angegeben. Beispielsweise kann mittels des Verfahrens ein optoelektronisches Halbleiterbauteil hergestellt werden, wie es in Verbindung mit einem oder mehrerer der oben genannten Ausführungsformen beschrieben ist.

Das Verfahren weist die folgenden Verfahrensschritte auf:
- Bereitstellen eines Anschlussträgers mit einer Anschlussseite,
- Bereitstellen mindestens eines Halbleiterchips,
- Anbringen des Halbleiterchips auf der Anschlussseite,
- Aufbringen einer Zwischenfolie auf der Anschlussseite, und
- Erstellen eines Vergusskörpers.

Das Bereitstellen des mindestens einen Halbleiterchips kann auch derart geschehen, dass der Halbleiterchip auf einem geeigneten Anschlussträger, beispielsweise epitaktisch, aufgewachsen wird. Hierbei stellt die Anschlussseite bevorzugt eine geeignete Aufwachsfläche dar, etwa in Form eines Halbleitermaterials. Der Verfahrensschritt des Aufbringens des Halbleiterchips ist in diesem Falle im Verfahrensschritt des Bereitstellens beinhaltet. Das Verfahren kann zumindest teilweise im Wafer-Verbund stattfinden.

Ein solches Verfahren ermöglicht es, effizient alterungsstabile optoelektronische Bauteile herzustellen.

Gemäß zumindest einer Ausführungsform des Verfahrens wird die Zwischenfolie ganzflächig auf der Anschlussseite sowie auf dem mindestens einen Halbleiterchip aufgebracht. Die Folie überdeckt also durchgängig die Anschlussseite und die sich darauf befindlichen Halbleiterchips. Ein derartiges Aufbringen der Zwischenfolie kann einfach realisiert werden und senkt die Herstellungskosten.

Gemäß dem Verfahren umfasst das Aufbringen der Zwischenfolie die Schritte:
- Auflaminieren einer teilvernetzten Zwischenfolie, und
- Aushärten der auflaminierten Zwischenfolie.

Bei der teilvernetzten Zwischenfolie handelt es sich um eine Silikonfolie, die in noch weichem, duktilem oder zähflüssigem Zustand auf die Anschlussseite des Anschlussträgers aufgebracht wird. Die teilvernetzte Zwischenfolie kann sich hierdurch gut der Oberflächenstruktur des Anschlussträgers, sowohl mikro- als auch makroskopisch, anpassen. In dem nachfolgenden Verfahrensschritt wird die auflaminierte Zwischenfolie voll vernetzt beziehungsweise ausgehärtet. Dies kann etwa temperaturinduziert oder mittels UV-Strahlung geschehen. Die durch das Aushärten bedingte Volumenschrumpfung der Zwischenfolie beträgt bevorzugt weniger als 10%, besonders bevorzugt weniger als 3%. Dieses zweistufige Aufbringen der Zwischenfolie birgt den Vorteil, dass eine besonders gute Haftung der Zwischenfolie am Anschlussträger bewirkt wird.

Gemäß zumindest einer Ausführungsform des Verfahrens wird der Vergusskörper mittels Compression Molding erstellt, wobei der Anschlussträger beziehungsweise dessen Anschlussseite einen Teil der Gussform bildet. Beim Compression Molding wird üblicherweise eine Gießfolie verwendet, auf die anschließend die Gussform aufgedrückt wird. Über die Gießfolie wird die Gussform abgedichtet. Je nach Ausgestaltung der Zwischenfolie kann die Gießfolie entfallen, da eine ausreichende Abdichtung zwischen Gussform und Anschlussträger über die Zwischenfolie erfolgen kann. Mit anderen Worten kann die Zwischenfolie neben ihrer Eigenschaft als Haftvermittler auch eine Gießfolie für das Compression Molding-Verfahren darstellen. Compression Molding vereinfacht das Herstellungsverfahren und reduziert die Herstellungskosten.

Gemäß zumindest einer Ausführungsform des Verfahrens werden in der Zwischenfolie Aussparungen mittels Laserablation erzeugt. Für die Laserablation ist die Zwischenfolie bevorzugt in einem Spektralbereich absorbierend ausgestaltet. Beispielsweise kann die Zwischenfolie unterhalb vom etwa 400 nm absorbierend sein, so dass zum Beispiel Laserstrahlung im UV-Spektralbereich von der Folie absorbiert wird und diese sich somit ablatieren lässt. Bevorzugt wird für die Laserablation ein Kurzimpulslaser mit Impulsdauern im Nanosekundenbereich oder auch im Femtosekundenbereich verwendet. Insbesondere geeignet sind frequenzverdreifachte Festkörperlaser. Die Laserstrahlung kann auf die Zwischenfolie fokussiert werden. Je nach Erfordernissen kann die Größe des Fokusdurchmessers über geeignete Optiken angepasst werden, so dass sich automatisch eine bestimmte Strukturgröße ergibt. Beträgt der Fokusdurchmesser beispielsweise 20 µm, so lassen sich auf einfache Art und Weise etwa Aussparungen mit einem Durchmesser von 20 µm erzeugen. Alternativ kann auch mittels der Laserstrahlung die Zwischenfolie abgerastert werden, so dass auch größere, durchgehende Muster in dieser hergestellt werden können. Neben Kurzimpulslasern ist es prinzipiell auch möglich, insbesondere beim Abrastern fokussierte Dauerstrichlaser mit geeigneten Wellenlängen zu verwenden. Mittels Laserablation können besonders einfach und schonend für die unter der Zwischenfolie liegenden Strukturen beziehungsweise Schichten Aussparungen mit hoher Genauigkeit in dieser erzeugt werden.

Nötige Aussparungen etwa für die elektrische Kontaktierungen von Halbleiterchips können neben Laserablation alternativ etwa durch lithografische Verfahren oder Ätzverfahren ebenso erzeugt werden. Auch mechanische Methoden, wie beispielsweise Präzisionsfräsen, sind denkbar.

Einige Anwendungsbereiche, in denen hier beschriebene optoelektronische Bauteile Verwendung finden könnten, sind etwa die Hinterleuchtungen von Displays oder Anzeigeeinrichtungen. Weiterhin können die hier beschriebenen optoelektronischen Bauteile etwa auch in Beleuchtungseinrichtungen zu Projektionszwecken, in Scheinwerfern oder Lichtstrahlern oder bei der Allgemeinbeleuchtung eingesetzt werden.

Nachfolgend wird ein hier beschriebenes Bauteil sowie ein hier beschriebenes Verfahren unter Bezugnahme auf die Zeichnung anhand von Ausführungsbeispielen näher erläutert.

Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Schnittdarstellung eines Ausführungsbeispiels,
- Figur 2: eine schematische Schnittdarstellung eines weiteren Ausführungsbeispiels,
- Figur 3: eine schematische Schnittdarstellung eines Ausführungsbeispiels mit Fresnel-Linse,
- Figur 4: eine schematische Schnittdarstellung eines weiteren Ausführungsbeispiels,
- Figur 5: eine schematische Schnittdarstellung eines Ausführungsbeispiels mit mehreren Halbleiterchips,
- Figur 6: eine schematische Schnittdarstellung eines Ausführungsbeispiels mit einem Dünnfilmchip, und
- Figur 7a-f: schematische Schnittdarstellungen verschiedener Verfahrensschritte der Herstellung eines Ausführungsbeispiels.

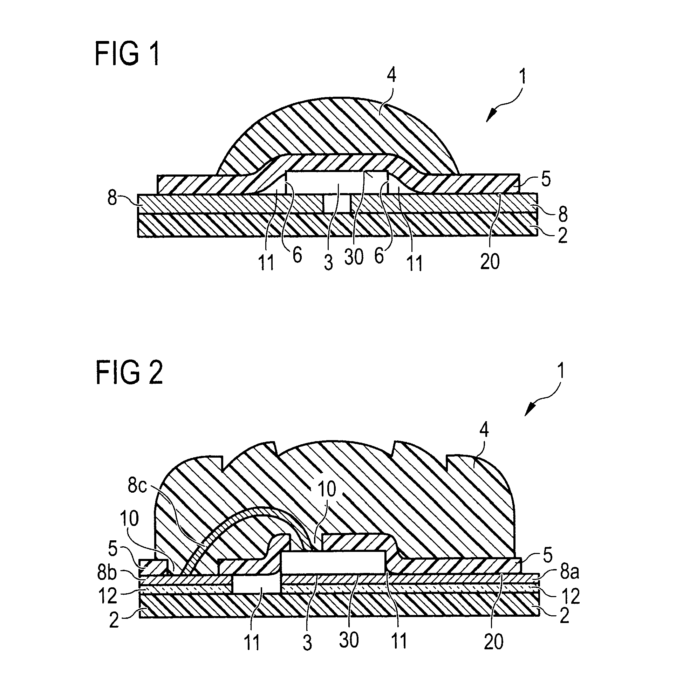

In Figur 1 ist ein Ausführungsbeispiel eines optoelektronischen Halbleiterbauteils 1 gezeigt. Auf einer eben ausgestalteten Anschlussseite 20 eines Anschlussträgers 2, der aus einem keramischen Werkstoff mit hoher Wärmeleitfähigkeit hergestellt ist, sind elektrische Leitungen 8 angebracht. Auf der dem Anschlussträger 2 abgewandten Seite der elektrischen Leitungen 8 ist ein optoelektronischer Halbleiterchip 3 angebracht. Die elektrische Verbindung zwischen Halbleiterchip 3 und elektrischen Leitungen 8 ist zum Beispiel mittels elektrisch leitfähigem Kleber erfolgt.

Die dem Anschlussträger 2 abgewandte Seite des Halbleiterchips 3 bildet dessen Strahlungsdurchtrittsfläche 30. Die Chipflanken 6 werden durch die senkrecht zur Strahlungsdurchtrittsfläche 30 ausgerichteten Begrenzungsflächen des Halbleiterchips 3 gebildet, die die Strahlungsdurchtrittsfläche 30 mit der dem Anschlussträger 2 zugewandten Seite des Halbleiterchips 3 verbinden. Über der Anschlussseite 20 ist eine Zwischenfolie 5 aufgebracht. Die Zwischenfolie 5 überdeckt elektrische Leitungen 8 und den Halbleiterchip 3. Die gesamte Strahlungsdurchtrittsfläche 30 des Halbleiterchips 3 ist ebenfalls von der Zwischenfolie 5 bedeckt. Die Zwischenfolie 5 ist hierbei eine Silikonfolie. Der als Flipchip ausgestaltete Halbleiterchip 3 weist eine Dicke in Richtung senkrecht zur Anschlussseite 20 von zirka 150 µm auf. Die Dicke der Silikonfolie 5 beträgt etwa 50 µm.

An den Chipflanken 6, eingeschlossen von der Zwischenfolie 5 und der Anschlussseite 20, ist ein Hohlraum 11 gebildet. Gemäß Figur 1 weist der Hohlraum 11 ein vergleichsweise kleines Volumen auf. Die Zwischenfolie 5 liegt teilweise an den Chipflanken 6 an. An der vom Anschlussträger 2 abgewandten Seite der Zwischenfolie 5 ist ein Vergusskörper 4 aufgebracht. Der Vergusskörper umgibt den Halbleiterchip 3 im Wesentlichen an dessen Strahlungsdurchtrittsfläche 30 sowie an den Chipflanken 6. Die mechanische Verbindung zwischen Vergusskörper 4 und Anschlussträger 2 ist über die Zwischenfolie 5 hergestellt. In den Bereichen, in denen sich der Halbleiterchip 3 befindet, erfolgt die Verbindung der Zwischenfolie 5 zum Anschlussträger 2 indirekt über den Halbleiterchip 3, das heißt, die Zwischenfolie 5 haftet auf dem Halbleiterchip 3, der wiederum auf dem Anschlussträger 2 haftet.

Der Halbleiterchip 3 kann beispielsweise als Leuchtdiode ausgestaltet sein. Die Materialien des Vergusskörpers 4 und der Zwischenfolie 5 sind bevorzugt so zu wählen, dass die vom Halbleiterchip 3 in dessen Betrieb emittierte elektromagnetische Strahlung vom Vergusskörper 4 nicht absorbiert wird. Durch eine linsenartige Formgebung des Vergusskörpers 4 wird das vom Halbleiterchip 3 emittierte Licht in einen bestimmten Raumbereich hin gelenkt.

Im Betrieb des Halbleiterchips 3 erhitzt sich dieser im Normalfall signifikant. Temperaturunterschiede zwischen Ruhezustand und Betriebstemperatur von 50 °C, oder gar 100 °C und mehr können auftreten. Durch die verschiedenen thermischen Ausdehnungen von Halbleiterchip 3 und Vergusskörper 4 treten mechanische Spannungen auf. Ausgehend von den Kanten des Halbleiterchips 3 besteht aufgrund der thermischen Ausdehnung die Gefahr einer Rissbildung im Vergusskörper 4. Neben der verbesserten Haftvermittlung zwischen Anschlussträger 2 und Vergusskörper 4 wird durch die Zwischenfolie 5, die aus einem auch in ausgehärtetem Zustand eine gewisse Flexibilität aufweisenden Silikon gestaltet sein kann, die mechanische Belastung aufgrund der Wärmeausdehnung reduziert. Die Zwischenfolie 5 wirkt als eine Art Puffer zwischen Halbleiterchip 3 und Vergusskörper 4.

Durch den Anschlussträger 2, die elektrischen Leitungen 8 und den Halbleiterchip 3 ist ein weiterer Hohlraum gebildet, der sich zwischen dem Anschlussträger 2 und dem Halbleiterchip 3 befindet. Der weitere Hohlraum grenzt nicht an die Zwischenfolie 5.

Optional kann der Anschlussträger 2 und auch die elektrischen Leitungen 8 aus einem Material ausgeformt sein, das für die vom Halbleiterchip 3 zu emittierende oder zu empfangende elektromagnetische Strahlung durchlässig ist. Dadurch kann ein auch allseitig zum Beispiel emittierendes Halbleiterbauteil realisiert werden. Alternativ können die elektrischen Leitungen 8 beispielsweise aus einem Metall ausgestaltet sein, so dass die vom Halbleiterchip 3 in Richtung Anschlussträger 2 etwa emittierte Strahlung von den elektrischen Leitungen 8 in Richtung Vergusskörper 4 reflektiert wird.

In Figur 2 ist ein weiteres Ausführungsbeispiel gezeigt. Der Aufbau ähnelt dem gemäß Figur 1. Der Anschlussträger 2 ist aus einem Metall gefertigt. Zur Vermeidung von Kurzschlüssen ist zwischen Leiterbahnen 8 und Anschlussträger 2 an den entsprechenden Stellen ein elektrischer Isolator 12 aufgebracht. Der Halbleiterchip 3 ist derart auf den elektrischen Leitungen 8 aufgebracht, dass die gesamte dem Anschlussträger 2 zugewandte Fläche des Halbleiterchips 3 auf der elektrischen Leitung 8a aufsitzt. Eine zweite elektrische Leitung 8c ist von der Lichtdurchtrittsfläche 30 zu einer weiteren elektrischen Leitung 8b geführt. Die als Bonddraht ausgeführte elektrische Leitung 8c ist durch Ausnehmungen 10 in der Zwischenfolie 5 geführt. Die Zwischenfolie 5 liegt an den Chipflanken 6 in diesem Ausführungsbeispiel dicht an, so dass der Hohlraum 11 nur ein sehr kleines Volumen einnimmt. Die elektrischen Leitungen 8a, 8b sind so ausgestaltet, dass sie als Reflektor für die vom Halbleiterchip 3 zu empfangende oder zu emittierende Strahlung dienen können. Der Vergusskörper 4 ist als Fresnel-Linse ausgestaltet. Hierdurch kann sich ein besonders flaches optoelektronisches Bauteil 1 ergeben.

Alternativ kann der Vergusskörper 4 auch andere Strukturierungen, wie etwa Rillen, aufweisen, die beispielsweise eine gerichtet Lichtabstrahlung, verbesserten Lichtein- oder Lichtaustritt, oder eine gleichförmige Lichtabstrahlung des Bauteils 1 bewirken können.

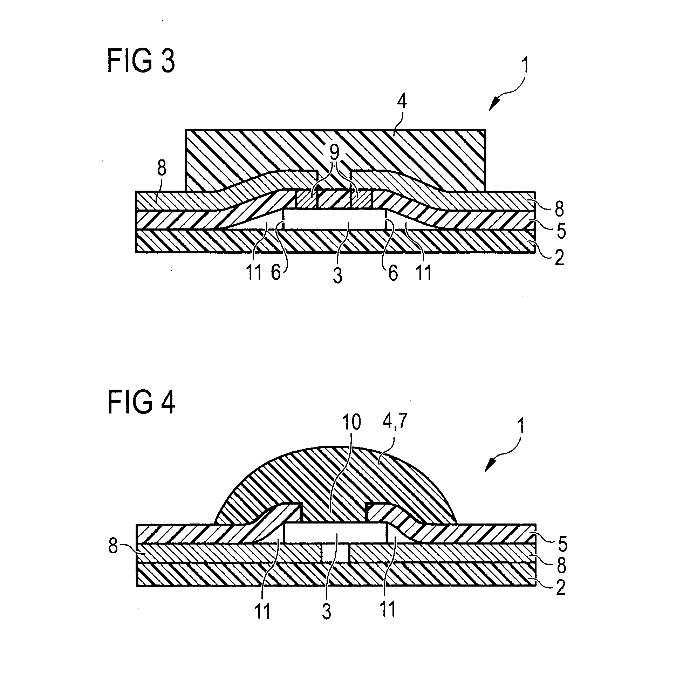

Im Ausführungsbeispiel gemäß Figur 3 ist der Halbleiterchip 3 auf einem Anschlussträger 2, der beispielsweise metallisch ausgestaltet sein kann, aufgeklebt. Die dem Anschlussträger 2 zugewandte Seite des Halbleiterchips 3 ist bevorzugt elektrisch isolierend ausgestaltet. Die Anschlussseite 20 des Anschlussträgers 2 wirkt reflektierend auf die vom Halbleiterchip 3 zu empfangende oder zu emittierende Strahlung. Alternativ kann der Halbleiterchip 3 als so genannter Top-Emitter ausgestaltet sein. Das heißt, die vom Halbleiterchip 3 zu emittierende Strahlung wird nahe der Strahlungsdurchtrittsfläche 30 erzeugt. Bei der Verwendung eines Top-Emitters sind keine reflektierenden Elemente etwa an der Anschlussseite 20 nötig.

Die Zwischenfolie 5 ist ganzflächig über Anschlussträger 2 und Halbleiterchip 3 aufgetragen. Der Hohlraum 11 ist relativ großvolumig ausgeprägt. Dadurch ist die Zwischenfolie 5, die die komplette Strahlungsdurchtrittsfläche 30 bedeckt und die Chipflanken 6 frei lässt, relativ flach zum Anschlussträger 2 hin auslaufend. Hierdurch wird es ermöglicht, dass die dem Anschlussträger 2 abgewandte Fläche der Zwischenfolie 5 nicht signifikant größer ist, als die Projektion dieser Fläche auf den Anschlussträger 2. Das bedeutet insbesondere, dass auf der Zwischenfolie 5, etwa mittels eines photolithographischen Verfahrens oder mittels Aufdampfen, elektrische Leitungen 8 erstellt werden können. Zur Kontaktierung des Halbleiterchips 3 sind Ausnehmungen 10 in der Zwischenfolie 5 an der dem Anschlussträger 2 abgewandten Seite des Halbleiterchips 3, die auch der Strahlungsdurchtrittsfläche 30 entspricht, angebracht.

Über die Ausnehmungen 10 erfolgt eine Durchkontaktierung 9 von den nicht gezeichneten Kontaktflächen des Halbleiterchips 3 zu den elektrischen Leitungen 8. Die Durchkontaktierungen 9 können ebenfalls etwa mittels eines photolithographischen Verfahrens erstellt werden. Die beispielsweise metallischen elektrischen Leitungen 8 nehmen nur einen kleinen Flächenanteil der Zwischenfolie 5 und der Strahlungsdurchtrittsfläche 30 ein. Der mit einer ebenen Oberfläche versehene Vergusskörper 4 haftet daher im Wesentlichen auf der Zwischenfolie 5 und über diese am Anschlussträger 2.

Optional kann der Zwischenträger 5 eine Beimengung 7 enthalten. Ist der Halbleiterchip 3 beispielsweise als Photodiode ausgestaltet, so kann über die Beimengung 7 der Spektralbereich, den der Halbleiterchip 3 detektieren soll, eingeschränkt werden. Mögliche Beimengungen 7 sind in diesem Falle zum Beispiel Pigmente oder Farbstoffe. Die Zwischenfolie 5 kann auch mehrere verschiedene Beimengungen 7 wie Konversionsmittel, Lumineszenzstoffe, Filtermittel oder Diffusionsmittel aufweisen.

Beim Ausführungsbeispiel gemäß Figur 4 ist der Vergusskörper 4 mit einer Beimengung 7 versehen. Die eine oder auch die mehrere Beimengungen 7 können beispielsweise wie in Figur 3 beschrieben gestaltet sein. Auch Beimengungen 7, die beispielsweise die mechanischen oder chemischen Eigenschaften des Vergusskörpers 4 beeinflussen, sind möglich. Der Halbleiterchip 3 ist, wie im Ausführungsbeispiel gemäß Figur 1, als Flipchip ausgeführt. Die elektrischen Leitungen 8 nehmen einen Großteil der dem Anschlussträger 2 zugewandten Seite des Halbleiterchips 3 ein. Der Halbleiterchip 3 ist mittels SMT-Löttechnik, also mittels Surface Mount Technology, mit den elektrischen Leitungen 8 und somit mit dem Anschlussträger 2 verbunden.

Die Zwischenfolie 5 weist in diesem Ausführungsbeispiel eine Ausnehmung 10 im Bereich der Strahlungsdurchtrittsfläche 30 auf, so dass diese von der Zwischenfolie 5 im Wesentlichen unbedeckt ist. Mit Ausnahme der Ausnehmung 10 ist die Zwischenfolie über dem gesamten Anschlussträger 2 aufgebracht.

Die Zwischenfolie 5 kann optional mit einem Strahlung undurchlässigen Material gestaltet sein, so dass zum Beispiel die elektrischen Leitungen 8 verdeckt sind. Hierdurch sind insbesondere die Leitungen 8 von außerhalb des Bauteils 1 nicht sichtbar.

Der Anschlussträger 2 kann etwa in Form einer bedruckten Leiterplatte mit mechanisch flexiblen Kunststoffsubstrat ausgestaltet sein.

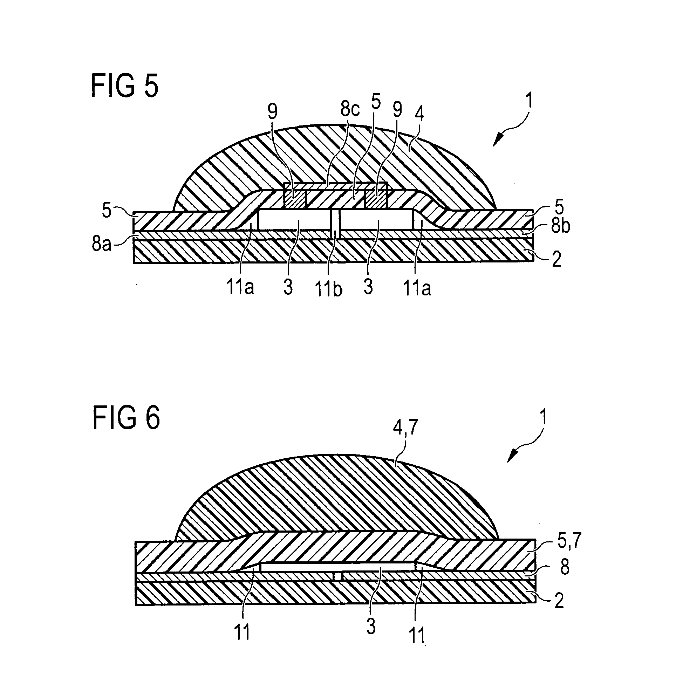

In Figur 5 ist ein Ausführungsbeispiel gezeigt, bei dem zwei Halbleiterchips 3 von einem einzigen Vergusskörper 4 überdeckt sind. Die Halbleiterchips 3, die beispielsweise als Laserdioden ausgeführt sein können, sind jeweils in der gesamten, dem Anschlussträger 2 zugewandten Fläche auf elektrischen Leitungen 8a, 8b aufgebracht. Die elektrischen Leitungen 8a, 8b sind metallisch ausgeführt und wirken reflektierend für die von den Halbleiterchips 3 zu emittierende oder zu empfangende elektromagnetische Strahlung. Der Anschlussträger 2 selbst wird mit einer bevorzugt thermisch leitfähigen Keramik gebildet. Die Zwischenfolie 5 überdeckt die beiden Halbleiterchips 3 derart, dass ein Hohlraum 11b zwischen den einander zugewandten Chipflanken 6 gebildet wird.

An den Strahlungsdurchtrittsflächen 30 der Halbleiterchips 3 weist die Zwischenfolie 5, die transparent für die von den Halbleiterchips 3 zu emittierende oder zu empfangende Strahlung ist, Ausnehmungen 10 auf. In diesen Ausnehmungen 10 befinden sich Durchkontaktierungen 9, die über eine elektrische Leitung 8b beide Chips miteinander elektrisch in Verbindung setzen. Hierdurch wird eine elektrische Reihenschaltung realisiert. Die Durchkontaktierungen 9 und die elektrische Leitung 8b können beispielsweise durch Aufdampfen erstellt sein. Sie nehmen nur eine geringe Fläche der Strahlungsdurchtrittsflächen 30 ein. Beide Halbleiterchips 3 sind von einem Vergusskörper 4, der linsenartig ausgestaltet ist, überdeckt. Anders als in Figur 5 gezeigt, kann der Vergusskörper 4 auch Sublinsen für jeden einzelnen Halbleiterchip 3 aufweisen.

Es ist auch möglich, dass mehrere Halbleiterchips 3 zweidimensional angeordnet sind, beispielsweise in einem 2 x 2 Muster. Die dann vier Halbleiterchips 3 können etwa aus zwei grün emittierenden, einem rot und einem blau emittierenden Halbleiterchip 3 bestehen und ergeben in Summe etwa eine Weißlichtquelle. Auch größere Arrays aus beispielsweise 3 x 3 oder 4 x 4 Halbleiterchips 3, die auch unregelmäßig angeordnet sein können, sind möglich. Insbesondere gilt dies, wenn der Anschlussträger 2 aus einem gut thermisch leitfähigen Material gestaltet ist und etwa zusätzlich Kontakt zu einer externen, nicht gezeichneten Wärmesenke hat.

Die Halbleiterchips 3 können, wie in Figur 5 gezeigt, in Serie geschaltet sein. Da über den Zwischenträger 5 eine isolierende Zwischenschicht beziehungsweise Abdeckschicht auf den Halbleiterchips 3 gegeben ist, ist es auf besonders einfache Art und Weise möglich, auch über den Strahlungsdurchtrittsflächen 30 der Halbleiterchips 3 elektrische Leitungen 8c anzubringen, die über Durchkontaktierungen 9 mit den Halbleiterchips 3 verbunden sind. Hierdurch kann sich ein hochdicht gepacktes Chiparray ergeben.

Alternativ zu der in Figur 5 gezeigten Reihenschaltung ist es ebenso möglich, dass die einzelnen Halbleiterchips 3, die in einer gewissen Farbe emittieren, parallel geschalten oder in separaten Stromkreisen angeordnet sind, um etwa die von den Halbleiterchips 2 emittierte Farbe über die Stromzuführung der Halbleiterchips 3 steuern und variieren zu können. Die elektrischen Leitungen 8c können dann im Wesentlichen parallel zu und über den elektrischen Leitungen 8a, 8b verlaufen. Die isolierende Zwischenfolie 5 ermöglicht es somit, auf einfache Art und Weise, eine zweilagige, sich beiderseits der Zwischenfolie 5 befindliche Leitungsführung zu realisieren.

Gemäß dem Ausführungsbeispiel in Figur 6, ist ein Dünnfilmchip 3 verwendet. Dieser Halbleiterchip 3 ist als Flipchip ausgeführt. Er weist eine Dicke von lediglich 6 µm auf. Die Zwischenfolie 5, die mit einer Beimengung 7 versehen ist, ist somit deutlich dicker als der Halbleiterchip 3 selbst. Durch die Verwendung sehr dünner Halbleiterchips 3 wird das Auflaminieren der Zwischenfolie 5 erleichtert, da im Vergleich zur Dicke der Zwischenfolie 5 die Strukturen auf der Anschlussseite 20 vergleichsweise klein sind. Der als Linse ausgeformte Vergusskörper 4 enthält ebenfalls eine Beimengung 7.

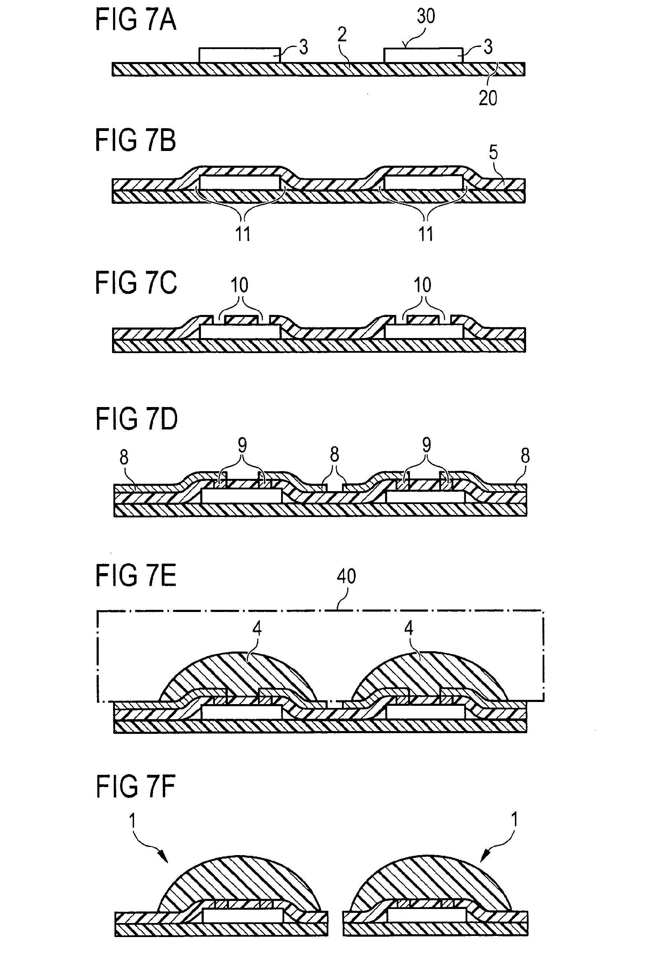

In den Figuren 7a bis 7f sind schematisch Verfahrensschritte zur Herstellung eines optoelektronischen Bauteils 1 dargestellt. Die in Figur 7 gezeigte Reihenfolge der Verfahrensschritte ist als vorteilhaft anzusehen, kann aber, je nach Erfordernissen, auch abgewandelt werden. Dies gilt insbesondere für den Schritt des Aufbringens der elektrischen Leitungen 8.

In einem ersten Verfahrensschritt gemäß Figur 7a wird ein Anschlussträger 2 und eine Mehrzahl von Halbleiterchips 3 bereitgestellt. Abweichend von Figur 7a können mehr als zwei Halbleiterchips 3 auf dem Anschlussträger 2 etwa mittels Kleben oder Löten oder epitaktischem Wachsen aufgebracht sein. Die Halbleiterchips 3 können auch in einem zweidimensionalen Muster angeordnet sein.

In einem nächsten Verfahrensschritt, siehe Figur 7b, wird ein Zwischenträger 5 auflaminiert. Der Zwischenträger 5 ist aus einer Silikonfolie gebildet. Bevorzugt ist das Aufbringen des Zwischenträgers 5 ein zweistufiger Prozess, das heißt, in einem ersten Schritt wird eine vorvernetzte Silikonfolie aufgebracht, die eine weiche oder zähflüssige Konsistenz aufweist. In einem zweiten Schritt wird die vorvernetzte Zwischenfolie 5 dann beispielsweise mittels UV-Strahlung oder Wärmebehandlung ausgehärtet. Durch das Aufbringen der vorvernetzten Zwischenfolie und dem anschließenden vollständigen Vernetzen wird ein besonders guter Kontakt zum Anschlussträger 2 gewährleistet, so dass die Zwischenfolie 5 gut am Anschlussträger 2 haftet.

In einem nächsten Verfahrensschritt, gezeigt in Figur 7c, sind Ausnehmungen 10 in der Zwischenfolie 5 erstellt. Dies kann beispielsweise mittels Laserablation erfolgen. Hierbei wird ein beispielsweise gepulster Laser, der bevorzugt eine Wellenlänge aufweist, die von der Zwischenfolie 10 absorbiert wird, auf die Zwischenfolie 5 fokussiert. Der Laser kann etwa ein bei 355 nm emittierender, frequenzverdreifachter Nd:YAG-Laser mit ns-Impulsen sein. Die Fokusgröße des Lasers kann beispielsweise die Strukturgrößen vorgeben. Ebenso ist es möglich, mittels eines Rasterverfahrens Strukturen in der Zwischenfolie 5 zu erzeugen. Alternativ können Ausnehmungen auch beispielsweise mittels lithographischer Verfahren, auch in Kombination mit Ätzverfahren, oder auch mechanisch, beispielsweise durch Fräsen, erstellt sein.

In Figur 7d ist gezeigt, dass elektrische Leitungen 8 und Durchkontaktierungen 9 auf der dem Anschlussträger 2 abgewandten Seite der Zwischenfolie 5 aufgebracht sind. Durchkontaktierungen 9 und elektrische Leitungen 8 nehmen nur einen sehr kleinen Anteil der dem Anschlussträger 2 abgewandten Fläche des Zwischenträgers 5 und somit auch der Strahlungsdurchtrittsflächen 30 ein. Da die elektrischen Leitungen 8 beispielsweise aufgedampft werden können, können auch komplexere Leitungsmuster einfach realisiert werden.

Alternativ ist es möglich, dass die Kontaktierungen der Halbleiterchips über die Anschlussseite 20 erfolgen, wie etwa in Figur 1 gezeigt, oder auf gegenüberliegenden Seiten des Halbleiterchips 3 über Bonddrähte, wie etwa in Figur 2 dargestellt.

In einem weiteren Verfahrensschritt, dargestellt in Figur 7e, wird eine Gießform 40 auf dem Anschlussträger 2 aufgepresst. Der Anschlussträger 2 bildet hierbei einen Teil der für das Gießen maßgeblichen Form. Je nach Ausgestaltung der Zwischenfolie 5 ist es möglich, auf eine üblicherweise verwendete Dichtfolie, die an der Gießform 40 angebracht ist, zu verzichten, da die Zwischenfolie 5 eine ausreichende Dichtigkeit zwischen Gießform 40 und Anschlussträger 2 gewährleisten kann. Nach dem Aufbringen der Gießform 40 wird der Vergusskörper 4 dann gegossen. Die Haftvermittlung zwischen Vergusskörper 4 und Anschlussträger 2 erfolgt über die Zwischenfolie 5.

In einem weiteren Verfahrensschritt, siehe Figur 7f, können die Halbleiterchips 3 mit zugehörigen Vergusskörpern 4 vereinzelt werden, so dass sich eine Vielzahl von optoelektronischen Halbleiterbauteilen 1 ergibt.

Dieser Vereinzelungsschritt kann, je nach Erfordernissen, auch entfallen. Es ist dann möglich, dass verschiedenartig emittierende Halbleiterchips 3 beziehungsweise verschiedene Beimengungen 7, speziell Konversionsmittel, in verschiedenen Bereichen auf dem Anschlussträger 2 aufgebracht sind, so dass sich, in Entsprechung zum Ausführungsbeispiel gemäß Figur 5, etwa Weißlichtquellen ergeben können.

## Patentansprüche

1. Optoelektronisches Halbleiterbauteil (1) mit
- einem Anschlussträger (2) mit einer Anschlussseite (20),
- mindestens einem optoelektronischen Halbleiterchip (3), der Chipflanken (6) aufweist und der auf der Anschlussseite (20) angebracht und mit dem Anschlussträger (2) elektrisch verbunden ist,
- einer haftvermittelnden Zwischenfolie (5), die eine Silikonfolie umfasst oder aus einer Silikonfolie besteht und die auf der Anschlussseite (20) aufgebracht ist und diese zumindest stellenweise bedeckt, und
- mindestens einem strahlungsdurchlässigen Vergusskörper (4), der ein Silikon umfasst oder aus einem Silikon besteht und der den Halbleiterchip (3) zumindest teilweise umgibt, wobei der Vergusskörper (4) mittels der Zwischenfolie (5) mit dem Anschlussträger (2) mechanisch verbunden ist,
**dadurch gekennzeichnet, dass**
die Zwischenfolie (5), die Anschlussseite (20) und die Chipflanken (6) einen Hohlraum (11) einschließen.

2. Optoelektronisches Halbleiterbauteil (1) nach Anspruch 1, bei dem eine Strahlungsdurchtrittsfläche (30) des Halbleiterchips (3) mindestens stellenweise von der Zwischenfolie (5) bedeckt ist.

3. Optoelektronisches Halbleiterbauteil (1) nach Anspruch 1 oder 2, bei dem ein Winkel zwischen einer durch eine Strahlungsdurchtrittsfläche des Halbleiterchips (3) definierten Ebene und einer der Anschlussseite (20) abgewandten Fläche der Zwischenfolie (5) kleiner ist als 45°.

4. Optoelektronisches Halbleiterbauteil (1) nach einem der vorhergehenden Ansprüche, bei dem von dem Halbleiterchip (3), dem Anschlussträger (2) und elektrischen Leitungen (8) an der Anschlussseite (20) ein weiterer Hohlraum eingeschlossen ist, der mit einem Gas gefüllt oder evakuiert ist.

5. Optoelektronisches Halbleiterbauteil (1) nach einem der vorhergehenden Ansprüche, bei dem die Chipflanken (6) gänzlich von der Zwischenfolie (5) unbedeckt bleiben und eine Dicke der Zwischenfolie (5) zwischen 20 µm und 200 µm liegt.

6. Optoelektronisches Halbleiterbauteil (1) nach einem der vorhergehenden Ansprüche, bei dem der Vergusskörper (4) und/oder die Zwischenfolie (5) zumindest eine Beimengung in Form eines Diffusor-, Konversions- und/oder Filtermittels enthalten.

7. Optoelektronisches Halbleiterbauteil (1) nach einem der vorhergehenden Ansprüche, bei dem der Anschlussträger (2) mit einem Metall oder einer Metalllegierung, einem Kunststoff oder einer Keramik gestaltet ist.

8. Optoelektronisches Halbleiterbauteil (1) nach einem der vorhergehenden Ansprüche, bei dem die Zwischenfolie (5) Strahlung undurchlässig ist, und bei dem die Zwischenfolie (5) an der Strahlungsdurchtrittsfläche (20) mindestens stellenweise eine Ausnehmung (10) aufweist.

9. Optoelektronisches Halbleiterbauteil (1) nach einem der vorhergehenden Ansprüche, das bis auf den Anschlussträger (2), die Zwischenfolie (5) und den Vergusskörper (4) gehäusefrei ist.

10. Verfahren zur Herstellung eines optoelektronischen Halbleiterbauteils (1) gemäß Anspruch 1 mit den Schritten
- Bereitstellen eines Anschlussträgers (2) mit einer Anschlussseite (20),
- Bereitstellen mindestens eines Halbleiterchips (3),
- Anbringen des Halbleiterchips (3) auf der Anschlussseite (20),
- Aufbringen einer Zwischenfolie (5) auf der Anschlussseite (20), wobei die Zwischenfolie (5) eine Silikonfolie umfasst oder aus einer Silikonfolie besteht, und
- Erstellen eines Vergusskörpers (4), der ein Silikon umfasst oder aus einem Silikon besteht,
**dadurch gekennzeichnet, dass**
das Aufbringen der Zwischenfolie (5) die Schritte umfasst:
- Auflaminieren der Zwischenfolie (5) auf der Anschlussseite (20) in teilvernetztem Zustand, und
- Aushärten der auflaminierten Zwischenfolie (5) vor dem Erstellen des Vergusskörpers (4).

11. Verfahren nach Anspruch 10, wobei die Zwischenfolie (5) ganzflächig auf der Anschlussseite (20) sowie auf dem Halbleiterchip (3) aufgebracht wird.

12. Verfahren nach Anspruch 10 oder 11, wobei bei dem Aushärten eine Volumenschrumpfung der Zwischenfolie (5) weniger als 3 % beträgt.

13. Verfahren nach einem der Ansprüche 10 bis 12, wobei der Vergusskörper (4) mittels Compression Molding erstellt wird, und der Anschlussträger (2) einen Teil der Gussform bildet.

14. Verfahren nach einem der Ansprüche 10 bis 13, wobei in der Zwischenfolie (5) mindestens eine Aussparung (10) mittels Laser-Ablation erzeugt wird.

15. Verfahren nach einem der Ansprüche 10 bis 14, wobei ein Halbleiterbauteil (1) gemäß einem der Ansprüche 2 bis 9 hergestellt wird.

## Claims

1. Optoelectronic semiconductor component (1) comprising
- a connection carrier (2) having a connection side (20),
- at least one optoelectronic semiconductor chip (3), which has chip sidewalls (6) and which is fitted on the connection side (20) and is electrically connected to the connection carrier (2),
- an adhesion-promoting intermediate film (5) which comprises a silicone film or consists of a silicone film and which is applied on the connection side (20) and covers the latter at least in places, and
- at least one radiation-transmissive potting body (4), which comprises a silicone or consists of a silicone and which at least partly surrounds the semiconductor chip (3), wherein the potting body (4) is mechanically connected to the connection carrier (2) by means of the intermediate film (5),
**characterized in that**
the intermediate film (5), the connection side (20) and the chip sidewalls (6) enclose a cavity (11).

2. Optoelectronic semiconductor component (1) according to Claim 1, wherein a radiation passage surface (30) of the semiconductor chip (3) is covered by the intermediate film (5) at least in places.

3. Optoelectronic semiconductor component (1) according to Claim 1 or 2, wherein an angle between a plane defined by a radiation passage surface of the semiconductor chip (3) and a surface of the intermediate film (5) facing away from the connection side (20) is less than 45°.

4. Optoelectronic semiconductor component (1) according to any of the preceding claims, wherein a further cavity is enclosed by the semiconductor chip (3), the connection carrier (2) and electrical lines (8) at the connection side (20), said further cavity being filled with a gas or being evacuated.

5. Optoelectronic semiconductor component (1) according to any of the preceding claims, wherein the chip sidewalls (6) in their entirety are left such that they are not covered by the intermediate film (5), and a thickness of the intermediate film (5) is between 20 µm and 200 µm.

6. Optoelectronic semiconductor component (1) according to any of the preceding claims, wherein the potting body (4) and/or the intermediate film (5) contains at least one admixture in the form of a diffuser medium, conversion medium and/or filter medium.

7. Optoelectronic semiconductor component (1) according to any of the preceding claims, wherein the connection carrier (2) is fashioned with a metal or a metal alloy, a plastic or a ceramic.

8. Optoelectronic semiconductor component (1) according to any of the preceding claims, wherein the intermediate film (5) is non-transmissive to radiation, and wherein the intermediate film (5) has a cutout (10) at least in places at the radiation passage surface (20).

9. Optoelectronic semiconductor component (1) according to any of the preceding claims, which apart from the connection carrier (2), the intermediate film (5) and the potting body (4) is free of a housing.

10. Method for producing an optoelectronic semiconductor component (1) according to Claim 1 comprising the following steps:
- providing a connection carrier (2) having a connection side (20),
- providing at least one semiconductor chip (3),
- fitting the semiconductor chip (3) on the connection side (20),
- applying an intermediate film (5) on the connection side (20), wherein the intermediate film (5) comprises a silicone film or consists of a silicone film, and
- creating a potting body (4), which comprises a silicone or consists of a silicone,
**characterized in that**
applying the intermediate film (5) comprises the following steps:
- laminating the intermediate film (5) on the connection side (20) in a partly crosslinked state, and
- curing the laminated intermediate film (5) before the process of creating the potting body (4).

11. Method according to Claim 10, wherein the intermediate film (5) is applied over the whole area on the connection side (20) and on the semiconductor chip (3).

12. Method according to Claim 10 or 11, wherein, during curing, a volume shrinkage of the intermediate film (5) is less than 3%.

13. Method according to any of Claims 10 to 12, wherein the potting body (4) is created by means of compression moulding, and the connection carrier (2) forms a part of the mould.

14. Method according to any of Claims 10 to 13, wherein at least one cutout (10) is produced in the intermediate film (5) by means of laser ablation.

15. Method according to any of Claims 10 to 14, wherein a semiconductor component (1) according to any of Claims 2 to 9 is produced.

## Revendications

1. Composant semi-conducteur optoélectronique (1) comportant
- un support de connexion (2) avec un côté de connexion (20),
- au moins une puce à semi-conducteur optoélectronique (3), qui présente des flancs de puce (6) et qui est appliquée sur le côté de connexion (20) et est reliée électriquement avec le support de connexion (2),
- un film intermédiaire améliorant l'adhérence (5), qui comprend un film en silicone ou est constitué d'un film en silicone et qui est appliqué sur le côté de connexion (20) et recouvre celui-ci au moins par endroits, et
- au moins une masse de scellement perméable aux rayonnements (4), qui comprend un silicone ou est constituée d'un silicone et qui entoure au moins partiellement la puce à semi-conducteur (3), dans lequel la masse de scellement (4) est reliée mécaniquement au support de connexion (2) au moyen du film intermédiaire (5),
**caractérisé en ce que**
le film intermédiaire (5), le côté de connexion (20) et les flancs de puce (6) définissent un espace creux (11).

2. Composant semi-conducteur optoélectronique (1) selon la revendication 1, dans lequel une surface de passage du rayonnement (30) de la puce à semi-conducteur (3) est couverte au moins par endroits par le film intermédiaire (5).

3. Composant semi-conducteur optoélectronique (1) selon la revendication 1 ou 2, dans lequel un angle entre un plan défini par une surface du passage du rayonnement de la puce à semi-conducteur (3) et une surface du film intermédiaire (5) qui se détourne du côté de connexion (20) est inférieur à 45°.

4. Composant semi-conducteur optoélectronique (1) selon une des revendications précédentes, dans lequel un espace creux supplémentaire est défini par la puce à semi-conducteur (3), le support de connexion (2) et des lignes électriques (8) sur le côté de connexion (20), qui est rempli d'un gaz ou évacué.

5. Composant semi-conducteur optoélectronique (1) selon une des revendications précédentes, dans lequel les flancs de puce (6) restent totalement découverts par le film intermédiaire (5) et une épaisseur du film intermédiaire (5) est comprise entre 20 µm et 200 µm.

6. Composant semi-conducteur optoélectronique (1) selon une des revendications précédentes, dans lequel la masse de scellement (4) et/ou le film intermédiaire (5) contiennent au moins une addition sous forme d'un moyen de diffusion, conversion et/ou filtrage.

7. Composant semi-conducteur optoélectronique (1) selon une des revendications précédentes, dans lequel le support de connexion (2) est conçu avec un métal ou un alliage de métal, un plastique ou une céramique.

8. Composant semi-conducteur optoélectronique (1) selon une des revendications précédentes, dans lequel le film intermédiaire (5) est imperméable au rayonnement, et dans lequel le film intermédiaire (5) présente sur la surface de passage du rayonnement (20) au moins par endroits un évidement (10).

9. Composant semi-conducteur optoélectronique (1) selon une des revendications précédentes, qui est sans boîtier jusqu'au support de connexion (2), au film intermédiaire (5) et à la masse de scellement (4).

10. Procédé de fabrication d'un composant semi-conducteur optoélectronique (1) selon la revendication 1 comportant les étapes de :
- fourniture d'un support de connexion (2) avec un côté de connexion (20),
- fourniture d'au moins une puce à semi-conducteur (3),
- montage de la puce à semi-conducteur (3) sur le côté de connexion (20),
- application d'un film intermédiaire (5) sur le côté de connexion (20), le film intermédiaire (5) comprenant un film en silicone ou étant constitué d'un film en silicone, et
- élaboration d'une masse de scellement (4), qui comprend un silicone ou est constituée d'un silicone,
**caractérisé en ce que**
l'application du film intermédiaire (5) comprend les étapes de :
- stratification du film intermédiaire (5) sur le côté de connexion (20) dans l'état partiellement réticulé, et
- durcissement du film intermédiaire (5) stratifié avant l'élaboration de la masse de scellement (4).

11. Procédé selon la revendication 10, dans lequel le film intermédiaire (5) est appliqué sur la totalité de la surface sur le côté de connexion (20) ainsi que sur la puce à semi-conducteur (3).

12. Procédé selon la revendication 10 ou 11, dans lequel lors du durcissement un retrait de volume du film intermédiaire (5) s'élève à moins de 3 %.

13. Procédé selon une des revendications 10 à 12, dans lequel la masse de scellement (4) est produit au moyen d'un moulage par compression, et le support de connexion (2) forme une partie du moule.

14. Procédé selon une des revendications 10 à 13, dans lequel dans le film intermédiaire (5) au moins un évidement (10) est produit au moyen d'une ablation au laser.

15. Procédé selon une des revendications 10 à 14, dans lequel un composant semi-conducteur (1) est produit selon une des revendications 2 à 9.
